# EUROPEAN PATENT APPLICATION

(11) **EP 4 561 275 A1**
(43) Date of publication of application: **28.05.2025**
(21) Application number: 22951773.5
(22) Date of filing: 31.10.2022
(51) Int. Cl.: H05K 5/00

(54) **CONTROLLER HOUSING, CENTRAL CONTROLLER, AND AUTOMOBILE**

(30) Priority: 20.07.2022 CN 202210863000
(71) Applicant: Voyah Automobile Technology Company Ltd., Hanyang District Wuhan City, Hubei 430050 (CN)
(72) Inventor: GUO, Wentao, Wuhan, Hubei 430050 (CN); CHEN, Qing, Wuhan, Hubei 430050 (CN); LI, Yueqing, Wuhan, Hubei 430050 (CN); HUANG, Qiguang, Wuhan, Hubei 430050 (CN); FENG, Fei, Wuhan, Hubei 430050 (CN)
(74) Representative: Boult Wade Tennant LLP
(86) International application number: PCT/CN2022/128803
(87) International publication number: WO 2024/016510

(57) **Abstract**

Disclosed herein are a housing (100) of a central controller, a central controller (1000), and a vehicle. The housing (100) of the central controller is divided into at least a first cavity and a second cavity by a combination of a middle frame (110), a first cover body (120), and a second cover body (130). Control components can be integrated into at least two small-area circuit boards, reducing the area of a single circuit board to facilitate installation and improving the modal of the circuit boards to reduce various vibration and impact loads during working.

## Description

### CROSS-REFERENCE TO RELATED APPLICATIONS

This application claims priority to Chinese Patent Application No. 202210863000.9, filed July 20, 2022, and titled "Housing of Controller, Central Controller, and Vehicle", which is hereby incorporated by reference in its entirety.

### TECHNICAL FIELD

The present disclosure belongs to the field of integrated control technology for vehicles, and, in particular, to a housing of a controller, a central controller, and a vehicle.

### BACKGROUND

Central controller is a core component of electric vehicles, and usually includes control components such as a motor controller, an entire vehicle controller, an entire vehicle management system, and an on-board charger. When these control components are integrated into an integrated central controller circuit board, the circuit board has a large area, which cannot meet installation and modal requirements.

### SUMMARY

The present disclosure aims to solve the technical problem at least to some extent that the integrated central controller circuit board cannot meet the installation and modal requirements due to large area. Therefore, the present disclosure provides a housing of a controller, a central controller, and a vehicle.

In a first aspect of the present disclosure, a housing of a central controller is provided, including: a middle frame; a first cover body, which is provided on a first side of the middle frame to form a first cavity between the first cover body and the middle frame; and, a second cover body, which is provided on a second side of the middle frame to form a second cavity between the second cover body and the middle frame.

In a second aspect of the present disclosure, a central controller is provided, including the aforementioned housing of the central controller and first and second circuit boards disposed within the housing of the central controller.

In a third aspect of the present disclosure, a vehicle is provided, including the aforementioned central controller.

### BRIEF DESCRIPTION OF DRAWINGS

To describe the technical solutions in embodiments of the present application more clearly, the following briefly introduces the accompanying drawings required for the description of the embodiments. Apparently, the accompanying drawings in the following description are some embodiments of the present invention, and persons of ordinary skill in the art may still derive other drawings from these accompanying drawings without creative effort.
FIG. 1 shows a schematic structural diagram of a central controller in some embodiments of the present disclosure.
FIG. 2 shows an exploded view of the central controller in FIG. 1.
FIG. 3 shows a schematic structural diagram of a middle frame of a housing of the central controller in FIG. 2.
FIG. 4 shows a schematic structural diagram of the middle frame in FIG. 3 viewed from another angle.
FIG. 5 shows a schematic structural diagram of a first cover body of the housing of the central controller in FIG. 2.
FIG. 6 shows a schematic structural diagram of a second cover body of the housing of the central controller in FIG. 2.
FIG. 7 shows a schematic structural diagram of a cooling device of the central controller in FIG. 2.
FIG. 8 shows an exploded view of the cooling device in FIG. 7.
FIG. 9 shows a schematic diagram of an installation state of the cooling device in the middle frame of FIG. 7.
FIG. 10 shows an exploded view of a housing and a cooling device of the central controller in FIG. 2.
FIG. 11 shows an exploded view of a housing of the central controller in FIG. 2.
FIG. 12 shows a schematic structural diagram of a first circuit board of the central controller in FIG. 2.
FIG. 13 shows a schematic structural diagram of a second circuit board of the central controller in FIG. 2.

### Reference numbers:

100-Housing; 110-Middle frame; 111-Partition; 112-Side wall; 113-First middle frame electromagnetic shielding enclosure wall; 114-First electromagnetic radiation interruption portion; 115-Cooling avoidance area; 116-Connector avoidance area; 117-First connector electromagnetic shielding enclosure wall; 118-Second connector electromagnetic shielding enclosure wall; 120-First cover body; 121-First cover body electromagnetic shielding enclosure wall; 130-Second cover body; 200-Cooling device; 210-Cooling plate; 211-Cooling plate body; 212-Cooling channel; 213-First positioning hole; 214-Second positioning hole; 220-First heat dissipation plate; 221-First heat dissipation plate body; 222-First thermal conductive protrusion; 230-Second heat dissipation plate; 231-Second heat dissipation plate body; 300-First circuit board; 310-First edge electromagnetic shielding wire; 400-Second circuit board; 410-Second edge electromagnetic shielding wire; 500-Connecting frame; 1000-Central controller.

### DESCRIPTION OF EMBODIMENTS

A clear and complete description of the technical solutions in the embodiments of the present disclosure will be provided below in conjunction with the accompanying drawings of embodiments of the present disclosure. Obviously, the described embodiments are only some of embodiments of the present disclosure, not all of them. Based on the embodiments in the present disclosure, all other embodiments obtained by ordinary skilled persons in this field without creative labor are within the protection scope of the present disclosure.

In addition, the present disclosure may repeat reference numbers and/or reference letters in different examples, and such repetition is for purpose of simplification and clarity, and does not in itself indicate the relationship between various embodiments and/or settings discussed. In addition, the present disclosure provides examples of various specific processes and materials, but those of ordinary skill in the art may be aware of the application of other processes and/or the use of other materials.

The present disclosure will be described below with reference to specific embodiments in conjunction with the accompanying drawings.

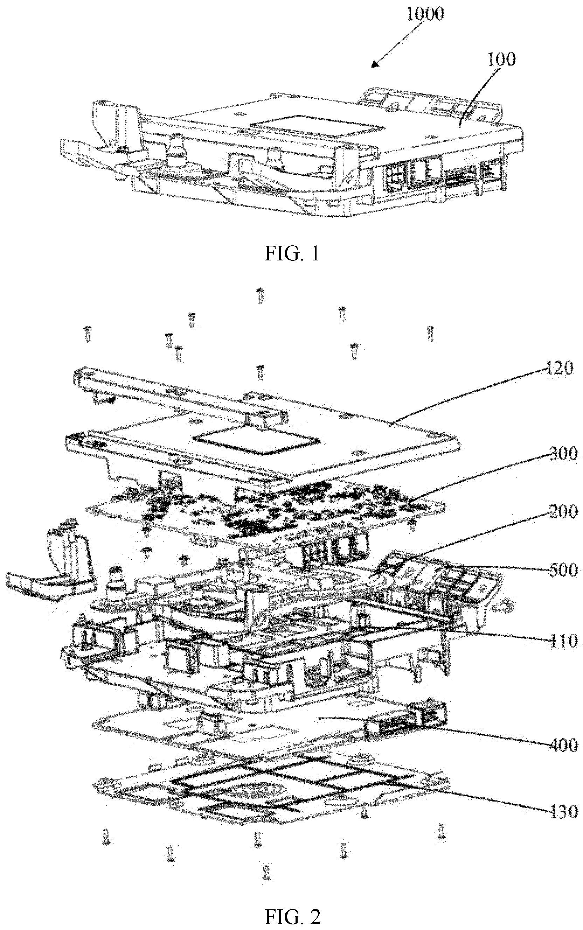

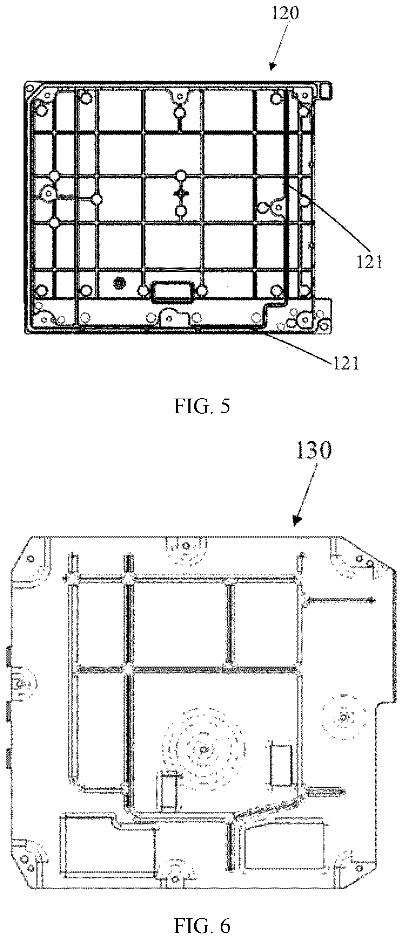

The present disclosure provides a housing 100 of a central controller 1000 in an embodiment, as shown in FIG. 1 to FIG. 6, The housing 100 of the central controller 1000 in the present embodiment includes: a middle frame110; a first cover body 120, which is provided on a first side of the middle frame 110 to form a first cavity between the first cover body 120 and the middle frame 110; and a second cover body 130, which is provided on a second side of the middle frame 110 to form a second cavity between the second cover body 130 and the middle frame 110.

In the present embodiment, the housing 100 is divided into at least the first cavity and the second cavity by combination of the middle frame 110 with the first cover body 120 and the second cover body 130. Control components of the central controller 1000 can be integrated into at least two small-area circuit boards through the first cavity and the second cavity, so that the circuit boards are arranged in parallel inside the housing 100 of the central controller 1000, not only reducing area of a single circuit board, which facilitates an installation of the circuit board, but also improving the modal of the circuit board, which reduces various types of vibration and impact loads that the circuit board bears during operation. At the same time, the circuit board is arranged in parallel in the first cavity and the second cavity, which ensures that the volume of the housing 100 of the central controller 1000 is relatively compact, reduces the maximum positive projection area of the housing 100, and facilitates setting of the central controller 1000 inside the vehicle.

In other embodiments, the housing 100 of the central controller 1000 may include several sequentially stacked middle frames 110. For example, the housing 100 of the central controller 1000 includes two stacked middle frames 110, and then a first cover body 120 and second cover body 130 are respectively provided on both sides of the two stacked middle frames 110. The housing 100 is divided into a first cavity, a second cavity, and a central cavity located between the first cavity and the second cavity by the two middle frames 110, so that three circuit boards can be provided inside the housing 100 of the central controller 1000.

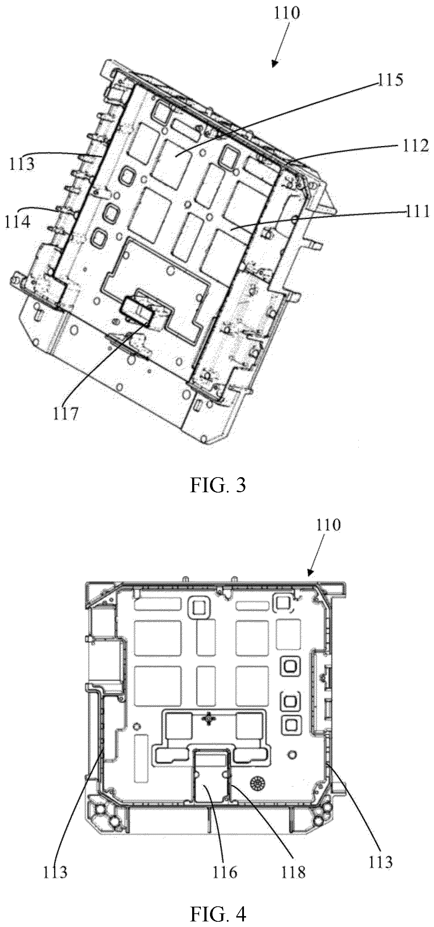

As an optional implementation, in the housing 100 of the central controller 1000 of the present embodiment, as shown in FIG. 3 and FIG. 4, the middle frame 110 of the present embodiment includes a partition 111 and a side wall 112 surrounding the partition 111.

In the present embodiment, the partition 111 of the middle frame 110 can divide the housing 100 into a first cavity and a second cavity, thereby forming two installation spaces inside the housing 100 to allow the setting of the circuit boards of the central controller 1000. In some embodiments, the partition 111 and the side wall 112 of the middle frame 110 can be used to fix structures such as circuit board and cooling device 200.

As shown in FIG. 3 and FIG. 4, the partition 111 of the present embodiment is provided with a connector avoidance area 116 for avoiding an inter-board connector.

In the present embodiment, the housing 100 of the central controller 1000 is provided with a first cavity and a second cavity, and a first circuit board 300 and a second circuit board 400 can be respectively provided in the first cavity and the second cavity, and the first circuit board 300 and the second circuit board 400 can be connected through an inter-board connector. A connector avoidance area 116 is provided on partition 111, which allows the inter-board connector to smoothly pass through the middle frame 110 to connect to the first circuit board 300 and the second circuit board 400, respectively.

Optionally, the inter-board connector can be a 3cm high-speed inter-board connector, achieving miniaturization of projection area and overall communication efficiency of larger than 8Gbps.

As shown in FIG. 3 and FIG. 4, the partition 111 of the present embodiment is provided with a cooling avoidance area 115 for avoiding the cooling device 200.

The circuit board of the central controller 1000 integrates multiple chips, so the heat generation of the circuit board is relatively high, and a corresponding cooling device 200 needs to be provided to dissipate heat from the circuit board. The first circuit board 300 and the second circuit board 400 may be separately provided with the cooling device 200 for heat dissipation. In order to simplify the overall structure of the central controller 1000, it is preferable to provide one cooling device 200 inside the housing 100 of the central controller 1000 to dissipate heat from both the first circuit board 300 and the second circuit board 400. In the present embodiment, the cooling device 200 can be provided on a first side or a second side of the middle frame 110, and can dissipate heat from the circuit board on the other side of the middle frame 110 through a cooling area on the partition 111 of the middle frame 110.

In the present embodiment, communication between the first side and the second side of the middle frame 110 may be achieved by providing the connector avoidance area 116, the cooling avoidance area 115 or other avoidance area on the partition 111 of the middle frame 110, so as to facilitate the setting of the inter-board connector, the cooling device 200 and other structures. Part of the partition 111 is reserved for fixing the circuit board, the cooling device and other structures, and for enhancing the structural strength of the middle frame 110.

In other embodiments, the middle frame 110 may be provided with only an enclosure wall without a partition 111, to facilitate the setting of the inter-board connector and the cooling device 200. For example, a mounting portion for fixing the circuit board and the cooling device 200 may be provided on the enclosure wall to facilitate the setting of the circuit board and the cooling device 200 inside the housing 100 of the central controller 1000.

As an optional implementation, as shown in FIG. 2, the housing 100 of the central controller 1000 of the present embodiment further includes a connecting frame 500, which can be detachably provided on the middle frame 110, the first cover body 120, or the second cover body 130.

In related technologies, in order to adapt to different vehicle models, it is necessary to provide different structures of the housing 100 of the central controller 1000. In the present embodiment, by detachably setting the connecting frame 500 and fixing the housing 100 of the central controller 1000 to the vehicle through the connecting frame 500, the housing 100 of the central controller 1000 can be applied across vehicle models. Different connecting frames 500 are configured for different vehicle models, and thus only the connecting frame 500 needs to be replaced with one that is adapted to the vehicle model when applying across vehicle models, reducing production cost of the central controller 1000 and improving economic efficiency.

Based on the same disclosure concept, an embodiment of the present disclosure also proposes a central controller 1000, which includes the above-mentioned housing 100 of the central controller 1000 and also a first circuit board 300 and a second circuit board 400 provided inside the housing 100 of the central controller 1000.

Since the central controller 1000 provided in the present disclosure includes the housing 100 of the central controller 1000 of the above technical solutions, the central controller 1000 provided in the present disclosure has all the beneficial effects of the housing 100 of the central controller 1000 as described above, which will not be repeated here.

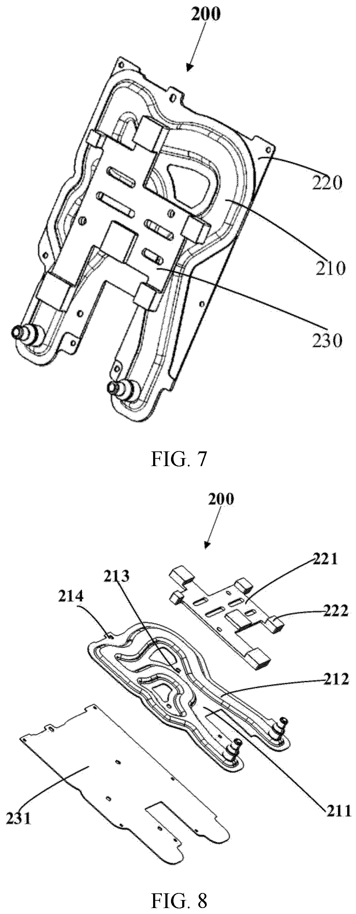

As shown in FIG. 2 and FIG. 8, the central controller 1000 also includes a cooling device 200, which is provided on the middle frame 110 to ensure that both sides of the cooling device 200 are respectively attached to the first circuit board 300 and the second circuit board 400.

With increasing integration of the circuit board in the central controller 1000 and growing demand for high computing power AI chips, the demand for heat dissipation in the central controller 1000 has also correspondingly increased to avoid heat damage to the electric components. In the present embodiment, a cooling device 200 is provided on the middle frame 110 of the central controller 1000, and meanwhile a corresponding cooling avoidance area 115 is provided on the partition 111 of the middle frame 110, so that the cooling device 200 provided on the middle frame 110 can simultaneously cool the first circuit board 300 and the second circuit board 400 on both sides of the middle frame 110 so as to dissipate heat therefrom. Optionally, in the present embodiment, the cooling device 200 can be fixed to the side wall 112 or the partition 111 of the middle frame 110 through bolts or other connecting component.

As shown in FIG. 7 to FIG. 9, the cooling device 200 includes: a cooling plate 210, which includes a cooling plate body 211 and a cooling channel 212 arranged inside the cooling plate 210; a first heat dissipation plate 220, which is provided on a first side of the cooling plate 210, and is used to attach to the first circuit board 300; and a second heat dissipation plate 230, which is provided on a second side of the cooling plate 210, and is used to attach to the second circuit board 400.

The above cooling device 200 includes a cooling plate 210, a first heat dissipation plate 220 provided on the first side of the cooling plate 210, and a second heat dissipation plate 230 provided on the second side of the cooling plate 210. With such cooling device 200 in split structure, the first circuit board 300 can be heat exchanged and cooled through the first heat dissipation plate 220, and also the cooling plate 210 can be isolated from the first circuit board 300 through the first heat dissipation plate 220, to avoid damage to the first circuit board 300 caused by leakage of the cooling channel 212 provided in the cooling plate body 211, thereby protecting the first circuit board 300 from damage. Similarly, the second circuit board 400 can be heat exchanged and cooled through the second heat dissipation plate 230, and also the cooling plate 210 can be isolated from the second circuit board 400 through the second heat dissipation plate 230, to avoid damage to the second circuit board 400 caused by leakage of the cooling channel 212 arranged inside the cooling plate body 211, thereby protecting the first circuit board 300 from damage.

In some embodiments, the above cooling device 200 can simultaneously cool the circuit boards located on both sides of the cooling device 200 through the first heat dissipation plate 220 and the second heat dissipation plate 230, avoiding the need for separately providing the cooling device 200 for each circuit board, and reducing the number of and space occupied by the cooling device 200.

In some embodiments, the above cooling device 200 can meet the heat dissipation needs of different circuit boards by replacing structure of the first heat dissipation plate 220 and the second heat dissipation plate 230 on both sides of the cooling plate 210, making the cooling plate 210 have a more wide range of applications.

In some embodiments, in the above cooling device 200, cooling water or refrigerant is circulated in the cooling channel 212.

In related technologies, the central controller 1000 can use air cooling for heat dissipation, mainly through air convection. The heat transfer efficiency of air natural convection is 5-25W/m² * K, which requires use of a large fin to meet the heat dissipation needs of the entire vehicle in harsh environment of 85 °C. In the present disclosure, water cooling heat dissipation can be used, and the forced convection coefficient of the water cooling heat dissipation can reach 1000-15000W/m² * K. Therefore, use of the water cooling heat dissipation can not only avoid the use of a large fins to reduce overall volume of the central controller 1000, but also have higher heat transfer efficiency to meet the heat dissipation needs of the entire vehicle in harsh environments.

In some embodiments, as shown in FIG. 7 to FIG. 9, the cooling channel 212 arranged inside the cooling plate 210 is provided with a cooling inlet and a cooling outlet, which can be connected to the cooling water circuit from the entire vehicle. According to the minimum flow rate of 1L/min, inlet water temperature of 55 °C, and outlet water temperature of 100 °C (the minimum junction temperature of the Automotive Grade Chip is 105 °C), if heat transfer area of the cooling plate 210 is 0.2m², then the heat transfer capacity of the cooling device 200 can be roughly calculated by the formula Q=K _{water} * 0.2 * 45 (K _{water} is 1000-15000W/m² * K) to be 900W~13500W, which is meet the future heat dissipation requirement of 1000500W of the central controller even considering the heat transfer losses caused by actual thermal conductive device.

As an optional implementation, as shown in FIG. 7 to FIG. 9, the first heat dissipation plate 220 of the present embodiment includes a first heat dissipation plate body 221, at least one first thermal conductive protrusion 222 is provided on a side of the first heat dissipation plate body 221 adjacent to the first circuit board 300, and the first thermal conductive protrusion 222 is used to be attached to a heating element on the first circuit board 300; and/or, the second heat dissipation plate 230 includes a second heat dissipation plate body 231, at least one second thermal conductive protrusion is provided on a side of the second heat dissipation plate body 231 adjacent to the second circuit board 400, and the second thermal conductive protrusion is used to adhere to a heating element on the second circuit board 400.

The circuit board of the central controller 1000 adopts an integrated design, not only there are multiple integrated chips on the circuit board, but also considering factors such as board area, the heat dissipation requirements vary depending on difference of position, height, and heat generation of the chips.

In the present embodiment, the cooling device 200 can cool the circuit board at a selected point. For example, before conducting a structural design on the first heat dissipation plate 220 and the second heat dissipation plate 230, a thermodynamic parameter simulation experiment is performed on each chip and element on the first circuit board 300 and the second circuit board 400. Based on a simulation result, a structural design of the first heat dissipation plate 220 and the second heat dissipation plate 230 is carried out. A corresponding first thermal conductive protrusion 222 is provided at a position of the first heat dissipation plate 220 corresponding to a main heat generation point on the first circuit board 300. Similarly, a corresponding second thermal conductive protrusion is provided at a position of the second heat dissipation plate 230 corresponding to a main heat generation point on the second circuit board 400. In this way, selected-point heat dissipation for the first circuit board 300 and the second circuit board 400 through the first thermal conductive protrusion 222 and the second thermal conductive protrusion, respectively, is achieved to improve heat dissipation efficiency.

As an optional implementation, as shown in FIG. 7 to FIG. 9, in the present embodiment, a flow path of the cooling channel 212 inside the cooling plate 210 passes through at least the first thermal conductive protrusion 222 and/or the second thermal conductive protrusion.

In the present embodiment, the positions where the first thermal conductive protrusion 222 and the second thermal conductive protrusion are provided are ones with a high heat dissipation demand. In order to further improve the heat transfer efficiency of the first thermal conductive protrusion 222 and the second thermal conductive protrusion with the cooling plate 210, the flow path of the cooling channel 212 in the cooling plate 210 should pass through at least the first thermal conductive protrusion 222 and/or the second thermal conductive protrusion, thereby achieving better heat dissipation effect. Correspondingly, the cooling avoidance area 115 provided on the middle frame 110 can be used for the first thermal conductive protrusion 222 or the second thermal conductive protrusion to be provided therein to dissipate heat from the circuit board.

As an optional implementation, in the present embodiment, a thermal conductive adhesive layer is provided between the first thermal conductive protrusion 222 and the first circuit board 300, and/or a thermal conductive adhesive layer is provided between the second thermal conductive protrusion and the second circuit board 400.

In the present embodiment, the thermal conductive adhesive layer can be prepared using a heat dissipation silicone material with thermal conductivity function. By providing the thermal conductive adhesive layer between the first thermal conductive protrusion 222 and the first circuit board 300, and/or between the second thermal conductive protrusion and the second circuit board 400, a flexible contact between chips on the circuit board and the thermal conductive protrusions can be achieved, thereby avoiding chip damage caused by vibration or other reasons under rigid contact between the chips and the thermal conductive protrusions.

As an optional implementation, as shown in FIG. 7 to FIG. 9, in the present embodiment, the first heat dissipation plate 220 and the cooling plate 210 are correspondingly provided with a first positioning hole 213, and the first heat dissipation plate 220 is connected with the cooling plate 210 by a first connecting piece and the first positioning hole 213; and/or, the second heat dissipation plate 230 and the cooling plate 210 are correspondingly provided with a second positioning hole 214, and the second heat dissipation plate 230 is connected with the cooling plate 210 by a second connecting piece and the second positioning hole 214.

In the present embodiment, the first heat dissipation plate 220 can be fixedly connected to the cooling plate 210 by the first connecting piece passing through the first positioning hole 213, and the second heat dissipation plate 230 can be fixedly connected to the cooling plate 210 by the second connecting piece passing through the second positioning hole 214. In some cases, the first positioning hole 213 and the second positioning hole 214 may overlap, that is, one connecting piece can sequentially pass through the first heat dissipation plate 220, the cooling plate 210, and the second heat dissipation plate 230 to achieve a positioning connection of the cooling device 200.

As a further optional implementation, in the present embodiment, the first heat dissipation plate 220 and/or the second heat dissipation plate 230 are fixed to the cooling plate 210 by brazing.

In the present embodiment, the first heat dissipation plate 220 and the second heat dissipation plate 230 can be first pre-positioned on the cooling plate 210 through a positioning pin, and then fixed to the cooling plate 210 by brazing. The brazing can be used to establish a sealed connection between a first thermal conductive plate and a water-cooling plate, as well as between a second thermal conductive plate and the water-cooling plate. The cooling channel 212 is enclosed by the first and second thermal conductive plates to prevent leakage of the cooling channel 212 into the circuit board due to machining accuracy, vibration, and other reasons.

As an optional implementation, in the present embodiment, the first thermal conductive protrusion 222 is fixed to the first heat dissipation plate 220 by brazing, and the second thermal conductive protrusion can be fixed to the second heat dissipation plate 230 by brazing.

In the present embodiment, the first heat dissipation plate 220 and the first thermal conductive protrusion 222 adopt a split design, and the first thermal conductive protrusion 222 can be flexibly provided on the first heat dissipation plate 220 according to heat dissipation requirements; and the second heat dissipation plate 230 is the same. This may achieve maximum degree of reuse of mold by providing an adjusted heat dissipation block after changes in circuit board structure, and reduce production cost.

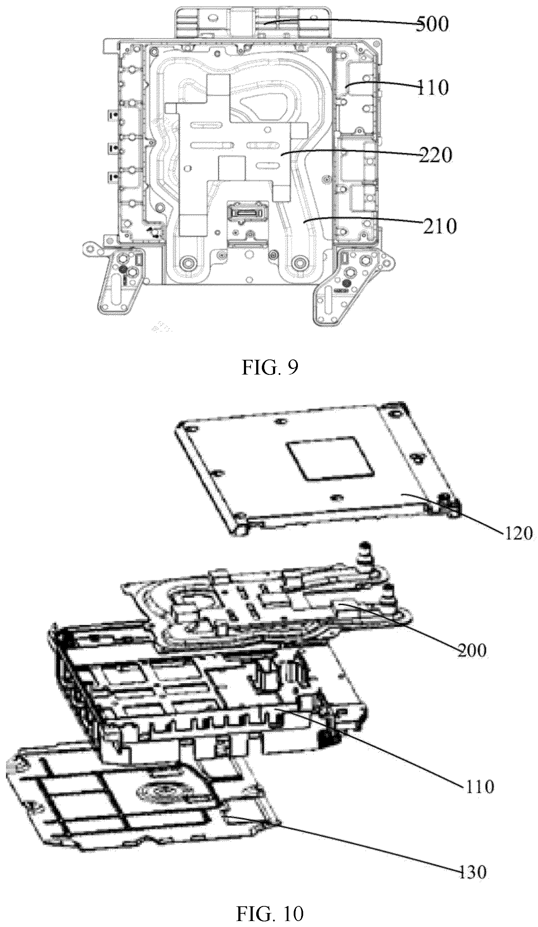

As an optional implementation, as shown in FIG. 2 and FIG. 9, the cooling device 200 can be connected as a whole to the middle frame 110 through a screw connection. Correspondingly, the first circuit board 300 and the second circuit board 400 can also be connected to the middle frame 110 through a screw connection, so that the first circuit board 300 and the second circuit board 400 are fixed to the middle frame 110 and cooled by the cooling device 200.

In some embodiments, the middle frame 110 may be provided with an assembly positioning portion corresponding to the cooling device 200 and an assembly positioning portion corresponding to the circuit board, so that the cooling device 200 and the circuit board can be accurately assembled to the middle frame 110 and the thermal conductive protrusion of the cooling device 200 corresponds to the chip on the circuit board.

As an optional implementation, both sides of the first circuit board 300 are provided with a first electromagnetic shielding layer; and both sides of the second circuit board 400 are provided with a second electromagnetic shielding layer; a first side of the middle frame 110 is provided with a first middle frame electromagnetic shielding enclosure wall 113, and a second side of the middle frame 110 is provided with a second middle frame 110 electromagnetic shielding enclosure wall; an inner side of the first cover body 120 is provided with a first cover body electromagnetic shielding enclosure wall 121 and the first cover body 120 is provided on the first side of the middle frame 110 so that the first cover body electromagnetic shielding enclosure wall 121 is abutted against the first middle frame electromagnetic shielding enclosure wall 113; and an inner side of the second cover body 130 is provided with a second cover body 130 electromagnetic shielding enclosure wall and the second cover body 130 is provided on the second side of the middle frame 110 so that the second cover body 130 electromagnetic shielding enclosure wall is abutted against the second middle frame 110 electromagnetic shielding enclosure wall.

In the present embodiment, by providing the first electromagnetic shielding layer on both sides of the first circuit board 300 respectively and providing the second electromagnetic shielding layer on both sides of the second circuit board 400 respectively, it is possible to achieve electromagnetic shielding between the first circuit board 300 and the second circuit board 400, and also electromagnetic shielding to the surface of the central controller 1000. Furthermore, the housing 100 of the control controller is also provided with electromagnetic shielding enclosure walls that cooperate with each other, and cooperation between the electromagnetic shielding enclosure walls achieves electromagnetic shielding around the central controller 1000, thereby achieving full shielding of the circuit board. That is, in the present embodiment, the first circuit board 300 forms a three-dimensional electromagnetic shielding in all directions by the first cover body 120, the middle frame 110, and the first circuit board 300 itself, and the second circuit board 400 forms a three-dimensional electromagnetic shielding in all directions by the second cover body 130, the middle frame 110, and the second circuit board 400 itself. Electromagnetic shielding between circuit boards and outward electromagnetic shielding of central controller 1000 are achieved through the cooperation between the circuit board and the housing 100.

As an optional implementation, in other embodiments, it is also possible to replace the electromagnetic shielding layer provided on the circuit board by setting an electromagnetic shielding layer on a surface of the housing 100 corresponding to a surface of the circuit board. For example, the inner side of the first cover body 120 is provided with a first cover body 120 electromagnetic shielding layer, and the first side of the middle frame 110 is provided with a first middle frame 110 electromagnetic shielding layer to replace the first electromagnetic shielding layer on both sides of the first circuit board 300; similarly, the inner side of the second cover 130 is provided with a second cover body 130 electromagnetic shielding layer, and the second side of the middle frame 110 is provided with a second middle frame 110 electromagnetic shielding layer to replace the second electromagnetic shielding layer on both sides of the second circuit board 400.

In the present embodiment, if power of the first circuit board 300 and the second circuit board 400 is small, the cooling device 200 may not be provided, that is, the cooling avoidance area 115 is not provided on the partition 111 of the middle frame 110, so that a complete first middle frame 110 electromagnetic shielding layer and a second electromagnetic shielding layer can be formed on the partition 111 of the middle frame 110. In the present embodiment, if power of the first circuit board 300 or the second circuit board 400 is large, the cooling device 200 needs to be provided, and the cooling avoidance area 115 needs to be provided on the partition 111 of the middle frame 110. In order to make the cooling avoidance area 115 have electromagnetic shielding function, an electromagnetic shielding layer can be provided on any one or more of the cooling plate 210, the first heat dissipation plate 220, and the second heat dissipation plate 230 of the cooling device 200 to replace the electromagnetic shielding layer on the middle frame 110, to achieve electromagnetic shielding between the first circuit board 300 and the second circuit board 400.

For the first circuit board 300, the first cover body 120 electromagnetic shielding layer, the first cover body electromagnetic shielding enclosure wall 121, the first middle frame 110 electromagnetic shielding layer, and the first middle frame electromagnetic shielding enclosure wall 113 form a complete enclosure around the first circuit board 300. Therefore, the first circuit board 300 can be electromagnetically isolated from the second circuit board 400 and other apparatuses, thereby achieving electromagnetic shielding for the first circuit board 300. The electromagnetic shielding of the second circuit board 400 is the same as that of the first circuit board 300, and will not be repeated here.

As an optional implementation, as shown in FIG. 3 and FIG. 10, a first electromagnetic radiation interruption portion 114 is provided between the first middle frame electromagnetic shielding enclosure wall 113 and the first cover body electromagnetic shielding enclosure wall 121; and a second electromagnetic radiation interruption portion is provided between the second middle frame 110 electromagnetic shielding enclosure wall and the second cover body 130 electromagnetic shielding enclosure wall.

In the present embodiment, due to the inability of the middle frame 110 to be absolutely parallel to the two circuit boards or the two cover bodies, it is impossible to achieve complete planar shielding. In order to improve the shielding effect, the present disclosure forms electromagnetic shielding grid structures between the middle frame 110 and the first cover body 120 and between the middle frame 110 and the second cover body 130 by providing the first electromagnetic radiation interruption portion 114 and the second electromagnetic radiation interruption portion, so that when the electromagnetic field passes through the electromagnetic shielding grid structures, eddy currents are generated, causing the electromagnetic field to be internally cancelled and ultimately achieving the electromagnetic shielding effect.

As an optional implementation, as shown in FIG. 3 and FIG. 10, in the present embodiment, a spacing between adjacent first electromagnetic radiation interruption portions 114 is 8cm to 12cm, and a spacing between adjacent second electromagnetic radiation interruption portions is 8cm to 12cm. In some embodiments, the spacing between adjacent first electromagnetic radiation interruption portions 114 may be 10cm, and the spacing between adjacent second electromagnetic radiation interruption portions is 10cm.

In the present embodiment, after experimental verification, a first harmonic frequency of signal frequency of an on-board device is less than 2GHz, and according to an electromagnetic wave shielding principle formula: λ_{cut.off}=2*a*, where a is an aperture diameter of shielding wall. For example, when the spacing *a* between the first electromagnetic radiation interruption portions 114 and the spacing *a* between the second electromagnetic radiation interruption portions are both 10cm, it can be calculated according to the formula f=c/λ=c/2a=2.794Ghz, where c=3*108m/s, that is, when the spacing between the first electromagnetic radiation interruption portions 114 and the second electromagnetic radiation interruption portions are both 10cm, a cut-off frequency for electromagnetic wave is 2.794GHz, that is, external radiation less than this frequency band can be isolated and shielded.

As an optional implementation, in the present embodiment, the first electromagnetic radiation interruption portion 114 includes a metal protrusion provided on the side wall 112 of the first side of the middle frame 110 and/or a metal protrusion provided on the side wall 112 of the first cover body 120; and the second electromagnetic radiation interruption portion includes a metal protrusion provided on the side wall 112 of second side of the middle frame 110 and/or a metal protrusion provided on the side wall 112 of the second cover body 130.

In the present embodiment, metal protrusions are provided on side walls 112 of the housing 100, similar metal grid structures are formed on the side walls 112 of the housing 100 to isolate the outward electromagnetic radiation of the central controller 1000 through the metal grid structures.

As an optional implementation, in the present embodiment, both sides of the first circuit board 300 are provided with first electromagnetic shielding layers, respectively; and the both sides of the second circuit board 400 are provided with second electromagnetic shielding layers, respectively.

In the present embodiment, by respectively setting the first electromagnetic shielding layers on both sides of the first circuit board 300, outward electromagnetic radiation shielding from upper and lower surfaces of the first circuit board 300 is achieved, and then, outward electromagnetic radiation shielding around the first circuit board 300 is achieved by the first cover body electromagnetic shielding enclosure wall 121 and the first middle frame electromagnetic shielding enclosure wall 113. Similarly, by respectively setting the second electromagnetic shielding layers on both sides of the second circuit board 400, outward electromagnetic radiation shielding from upper and lower surfaces of the second circuit board 400 is achieved, and then, outward electromagnetic radiation shielding around the second circuit board 400 is achieved by the second cover 130 electromagnetic shielding enclosure wall and the second middle frame 110 electromagnetic shielding enclosure wall.

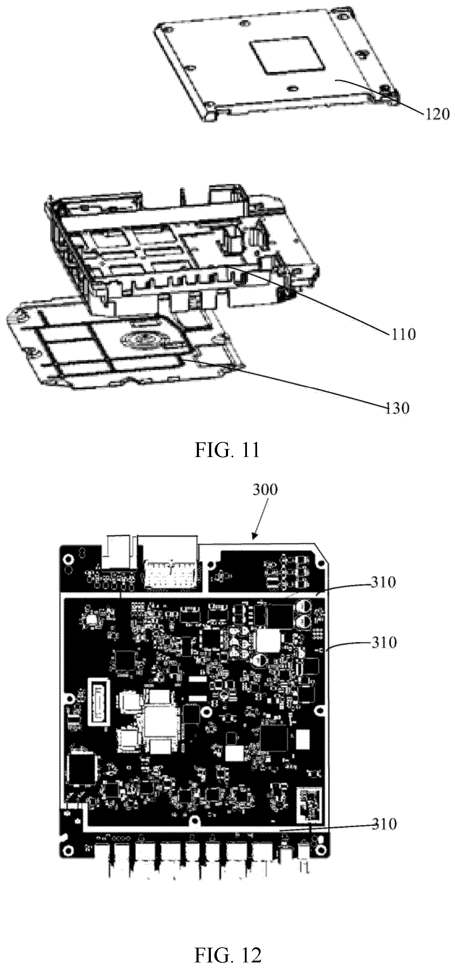

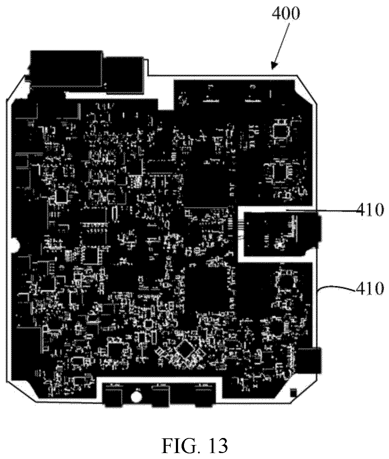

As an optional implementation, as shown in FIG. 12 and FIG. 13, in the present embodiment, an edge of the first circuit board 300 is provided with a first edge electromagnetic shielding wire 310, and an edge of the second circuit board 400 is provided with a second edge electromagnetic shielding wire 410.

In some embodiments, the first edge electromagnetic shielding wire 310 may be abutted against the first cover electromagnetic shielding enclosure wall 121 or the first middle frame electromagnetic shielding enclosure wall 113, and the second edge electromagnetic shielding wire 410 may be abutted against the second cover 130 electromagnetic shielding enclosure wall or the second middle frame 110 electromagnetic shielding enclosure wall.

As an optional implementation, as shown in FIG. 2 to FIG. 4, an inter-board connector is provided between the first circuit board 300 and the second circuit board 400. Correspondingly, the middle frame 110 is provided with a connector avoidance area 116, a first connector electromagnetic shielding enclosure wall 117 is provided on the first side of the middle frame 110 around the connector avoidance area 116, and a second connector electromagnetic shielding enclosure wall 118 is provided on the second side of the middle frame 110 around the connector avoidance area 116. Further preferably, the first circuit board 300, the second circuit board 400, and the corresponding position around the connector avoidance area 116 are provided with connector electromagnetic shielding wires.

In the present embodiment, in order to avoid electromagnetic interference between the first circuit board 300 and the second circuit board 400 through the connector avoidance area 116, a first connector electromagnetic shielding enclosure wall 117 is provided on the middle frame 110 around the connector avoidance area 116, to abut against the connector electromagnetic shielding wire located on the first circuit board 300, and a second connector electromagnetic shielding enclosure wall 118 is provided on the middle frame 110 around the connector avoidance area 116, to abut against the connector electromagnetic shielding wire located on the second circuit board 400, thereby enclosing the inter-board connector and avoiding electromagnetic interference between the circuit boards.

As an optional implementation, the electromagnetic shielding enclosure walls and the electromagnetic shielding layers are made of metal material, to achieve electromagnetic shielding effect through the metal material. Optionally, the metal material may be copper.

Based on the same disclosure concept, an embodiment in the present disclosure also provides a vehicle, which includes the central controller 1000 mentioned above.

Since the vehicle provided in the present disclosure includes the central controller 1000 of the above technical solution, the vehicle provided in the present disclosure has all the beneficial effects of the central controller 1000, which will not be repeated here.

It should be noted that all directional indications in the embodiments of the present disclosure are only used to explain relative position relationship, motion, etc. between components in a specific posture. If the specific posture changes, the directional indications will also change accordingly.

In addition, in the present disclosure, descriptions of "first", "second", etc. are only for descriptive purposes and should not be understood as indicating or implying their relative importance or implying the number of technical features indicated. Thus, the features defined by "first" and "second" may explicitly or implicitly include one or more such features as defined. In the description of the present disclosure, the meaning of "multiple" refers to two or more, unless otherwise specifically limited.

In addition, the technical solutions between various embodiments can be combined with each other, but they must be based on the fact that persons of ordinary skill in this field may implement them. When the combination of technical solutions is contradictory or impossible to implement it, it should be considered that this combination of technical solutions does not exist and is not within the protection scope of the present disclosure.

## Claims

1. A housing of a central controller, comprising:
a middle frame;
a first cover body, which is provided on a first side of the middle frame to form a first cavity between the first cover body and the middle frame; and,
a second cover body, which is provided on a second side of the middle frame to form a second cavity between the second cover body and the middle frame.

2. The housing of the central controller according to claim 1, wherein the middle frame comprises a partition and a side wall surrounding the partition.

3. The housing of the central controller according to claim 2, wherein the partition is provided with a connector avoidance area for avoiding an inter-board connector.

4. The housing of the central controller according to claim 2, wherein the partition is provided with a cooling avoidance area for avoiding a cooling device.

5. The housing of the central controller according to any one of claims 1 to 4, further comprising: a connecting frame, which is detachably provided on the middle frame, the first cover body, or the second cover body.

6. A central controller, comprising the housing of the central controller according to any one of claims 1 to 5, and a first circuit board and a second circuit board that are provided inside the housing of the central controller.

7. The central controller according to claim 6, further comprising: a cooling device, which is provided on the middle frame, so that both sides of the cooling device are attached to the first circuit board and the second circuit board, respectively.

8. The central controller according to claim 6, wherein both sides of the first circuit board are each provided with a first electromagnetic shielding layer; both sides of the second circuit board are each provided with a second electromagnetic shielding layer; the first side of the middle frame 110 is provided with a first middle frame electromagnetic shielding enclosure wall 113, and the second side of the middle frame 110 is provided with a second middle frame electromagnetic shielding enclosure wall;, an inner side of the first cover body 120 is provided with a first cover body electromagnetic shielding enclosure wall 121 and the first cover body is provided on the first side of the middle frame, so that the first cover body electromagnetic shielding enclosure wall is abutted against the first middle frame electromagnetic shielding enclosure wall; and, an inner side of the second cover body is provided with a second cover body electromagnetic shielding enclosure wall and the second cover body is provided on the second side of the middle frame, so that the second cover body electromagnetic shielding enclosure wall is abutted against the second middle frame electromagnetic shielding enclosure wall.

9. The central controller according to claim 8, wherein a first electromagnetic radiation interruption portion is provided between the first middle frame electromagnetic shielding enclosure wall and the first cover body electromagnetic shielding enclosure wall, and a second electromagnetic radiation interruption portion is provided between the second middle frame electromagnetic shielding enclosure wall and the second cover body electromagnetic shielding enclosure wall.

10. A vehicle, comprising: the central controller according to any one of claims 6 to 9.
